**Europäisches Patentamt**

**European Patent Office**

**Office européen des brevets**

(19)

(11) Veröffentlichungsnummer: **0 024 026**
**B1**

(12) **EUROPÄISCHE PATENTSCHRIFT**

(45) Veröffentlichungstag der Patentschrift:
**01.02.84**

(21) Anmeldenummer: **80104598.0**

(22) Anmeldetag: **04.08.80**

(51) Int. Cl³ **H 04 N 5/22,** H 04 H 7/00,
H 04 N 7/14

(54) Breitbandkoppelanordnung.

(30) Priorität: **10.08.79 DE 2932588**

(43) Veröffentlichungstag der Anmeldung:
**18.02.81 Patentblatt 81/7**

(45) Bekanntmachung des Hinweises auf die Patenterteilung:
**01.02.84 Patentblatt 84/5**

(84) Benannte Vertragsstaaten:
**AT BE CH DE FR GB IT LI NL SE**

(56) Entgegenhaltungen:
**US - A - 3 599 182**
**US - A - 3 838 296**

**REVIEW OF THE ELECTRICAL COMMUNICATION LABORATORIES, Band 25, Nummern 1-2, Jan.-Feb. 1977, Tokyo JP, M. SUNAZAWA et al.: "Wideband Integrated Crosspoint Switch Matrix" Seiten 43-49**

(73) Patentinhaber. **SIEMENS AKTIENGESELLSCHAFT, Berlin und München Wittelsbacherplatz 2, D-8000 München 2 (DE)**

(72) Erfinder: **Bauch, Helmut, Dr., Waldstrasse 3a, D-8130 Starnberg (DE)**
Erfinder: **Rehm, Hans, Dipl.-Ing, Wildenfelserstrasse 19, D-8000 München 60 (DE)**

## Breitbandkoppelanordnung

Die Erfindung bezieht sich auf eine Koppelanordnung zum wahlweisen Durchschalten von Signalen hoher Bandbreite, die insbesondere bei der Verteilung von Videosignalen Anwendung finden kann.

In einer solchen Breitband-Koppelanordnung können die Koppelpunktschaltkreise, deren Funktion es ist, Eingangsleitungen mit Ausgangsleitungen der Koppelanordnung wahlweise zu verbinden, im Hinblick auf möglichst kleine Schaltzeiten bzw. auf die durchzuschaltenden, vorzugsweise F-, PF- oder PC-modulierten Signale mit Signalfrequenzen von z. B. bis über 80 MHz durch in ECL-Technik realisierte Verknüpfungsglieder gebildet sein (s. Pfannschmidt: »Arbeitsgeschwindigkeitsgrenzen von Koppelnetzwerken für Breitband-Digitalsignale«, Diss. TU Bswg. 1978; DE-AS 2 828 662). Solche handelsüblichen Verknüpfungsglieder verursachen allerdings unabhängig von ihrem jeweiligen Schaltzustand Verlustleistungen, so daß größere Koppelfelder einen relativ hohen, größtenteils nutzlosen Leistungsverbrauch (s. auch Harthmuth, Duck, Jenik: »Aufbau und Anwendung integrierter Halbleiterschaltungen«, Regelungstechnik 16 (1968) 12, 541 ... 588, und 17 (1969) 1, 12 ... 18; Abschn. 3c) aufweisen.

Die Erfindung stellt sich nun die Aufgabe, einen solchen unnötigen Leistungsverbrauch zu vermeiden. Die Erfindung betrifft eine Breitband-Koppelanordnung mit Koppelpunktschaltkreisen in ECL-Technik, bei der jeweils eine Mehrzahl von Koppelpunktschaltern durch eine entsprechende Mehrzahl von auf einem Chip-Baustein zusammengefaßten Verknüpfungsgliedern realisiert ist; diese Koppelanordnung ist erfindungsgemäß dadurch gekennzeichnet, daß in eine allen diesen Verknüpfungsgliedern eines solchen Chip-Bausteins gemeinsame Betriebsspannungszuführung jedes solchen Chip-Bausteins ein nur in Abhängigkeit von einer verknüpfungsglied-inidividuellen Ansteuerung wenigstens eines Verknüpfungsgliedes des betreffenden Chip-Bausteins leitend gesteuerter Schalttransistor eingefügt ist.

Die Erfindung bringt neben den Vorteilen einer beträchtlichen Leistungseinsparung und damit geringerer Betriebskosten sowie geringerer Anforderungen an die Stromversorgungseinrichtungen eine Reihe weiterer Vorteile mit sich: So erlaubt die geringe Verlustwärme einen kompakten Aufbau, wobei Kühlungsmaßnahmen ganz entfallen oder zumindest wesentlich reduziert sein können; bei der Integration kann gegebenenfalls eine entsprechend große Anzahl von Bauelementen auf einem Baustein (Chip) zusammengefaßt werden. In einer größeren Koppelanordnung, in der die Anzahl der jeweils durchgeschalteten Koppelpunktschalter klein gegenüber der Gesamtzahl der Koppelpunktschalter ist, haben die Koppelpunktschalter eine entsprechend niedrige mittlere Betriebszeit und damit eine entsprechend lange Lebensdauer bzw. eine entsprechend reduzierte Ausfallrate; nachdem die jeweils im Sperrzustand befindlichen stromlosen Koppelpunktschaltkreise keine Signalverstärkung bewirken, wird in der Koppelanordnung zugleich eine größere Übersprechdämpfung erzielt und ein geringeres Rauschen erhalten.

Es sei an dieser Stelle bemerkt, daß (aus US-PS 3 838 296) bereits ein Multiplexer mit einer Reihe von selektiv mit Betriebsstrom versorgbaren Daten-Gatterschaltungen in ECL-Technik und einer dieser Reihe von Daten-Gatterschaltungen gemeinsamen Betriebsstromquelle bekannt ist, bei dem in die gatterschaltungsindividuelle Betriebsstromzuführung jeder Daten-Gatterschaltung ein eigenes Betriebsstrom-Gatter eingefügt ist, so daß bei individueller Ansteuerung dieses Betriebsstrom-Gatters nur die zugehörige Daten-Gatterschaltung von der Betriebsstromquelle gespeist wird.

Dieser bekannte Multiplexer erweist sich insofern als relativ aufwendig, als hier zusätzlich zu jeder Daten-Gatterschaltung auch eine ihr individuell zugehörige Betriebsstrom-Gatterschaltung vorgesehen sein muß. Die Erfindung ermöglicht es demgegenüber, ohne einen solchen Aufwand bei einer Breitbandkoppelanordnung dennoch zu einer beträchtlichen Leistungseinsparung zu gelangen, wobei die Erfindung sich die Erkenntnis zunutze macht, daß in einer Koppelanordnung, bei der jeweils eine Mehrzahl von Koppelpunktschaltern durch eine entsprechende Mehrzahl von auf einem Chip-Baustein zusammengefaßten Verknüpfungsgliedern realisiert ist, sich nicht immer ein Koppelpunktschalter eines Chip-Bausteins im Durchschaltezustand befindet und somit der Chip-Baustein keiner permanenten Stromzufuhr bedarf.

In weiterer Ausgestaltung der Erfindung können die Ansteuereingänge der einzelnen Verknüpfungsglieder des Chip-Bausteins über ein ODER-Glied mit dem Steuereingang des Schalttransistors verbunden sein; dies hat den Vorteil, daß das Schalten eines Koppelpunktschalters sowie der Stromversorgung des dazugehörigen Chip-Bausteins jeweils durch ein und dasselbe Steuersignal bewirkt werden kann.

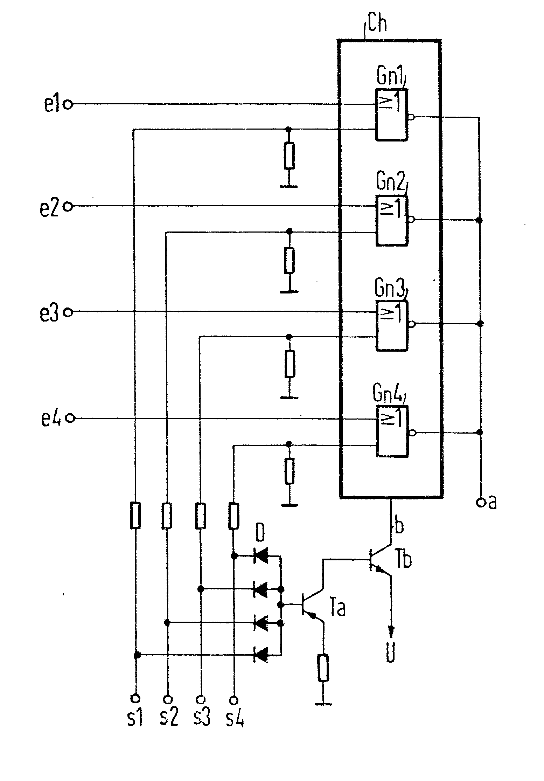

Anhand der Zeichnung sei die Erfindung noch näher erläutert.

In der Zeichnung ist eine Breitbandkoppelanordnung mit einer Mehrzahl von Eingangsleitungen e1 ... e4 und einer Ausgangsleitung a dargestellt, wobei in den Kreuzungspunkten der Eingangsleitungen mit der Ausgangsleitung Koppelpunktschalter liegen, die durch auf einem Chip-Baustein Ch zusammengefaßte Verknüpfungsglieder, beispielsweise NOR-Glieder Gn1 ... Gn4, gebildet sein mögen. Dabei ist jedes Verknüpfungsglied mit seinem einen Eingang an die zugehörige Eingangsleitung e und mit seinem Ausgang an die zugehörige Ausgangsleitung a angeschlossen;

mit seinem jeweils anderen Eingang liegt jedes Verknüpfungsglied Gn1 ... Gn4 an einer ihm individuell zugehörigen Ansteuerleitung s1 ... s4, über die der durch das jeweilige Verknüpfungsglied gebildete Koppelpunktschalter — zur TTL-ECL-Pegelanpassung über einen Spannungsteiler — in den Durchschaltezustand gesteuert oder auch wieder gesperrt werden kann.

Es sei an dieser Stelle bemerkt, daß die Koppelanordnung nicht auf die in der Zeichnung dargestellte Anzahl von Eingangs- bzw. Ausgangsleitungen e, a und/oder auf den dargestellten Baustein mit einer Spalte von Koppelpunktschaltern beschränkt zu sein braucht, vielmehr auch weitere Eingangsleitungen und/oder weitere Ausgangsleitungen aufweisen kann, wobei in jedem Kreuzungspunkt zwischen einer Eingangsleitung und einer Ausgangsleitung ein Koppelpunktschalter in Form eines Verknüpfungsgliedes liegt, wobei solche Verknüpfungsglieder auch mit weiteren Verknüpfungsgliedern auf weiteren Chip-Bausteinen zusammengefaßt sein können.

Um nun in einer solchen Breitbandkoppelanordnung, bei deren Betrieb ja stets nur eine relativ geringe Anzahl von Koppelpunktschaltern sich im Durchschaltezustand befindet, die nicht angesteuerten, d. h. nicht im Durchschaltezustand befindlichen Koppelpunktschalter soweit wie möglich verlustleistungsfrei zu halten, ist nun, wie dies aus der Zeichnung ersichtlich wird, in die Betriebsspannungszuführung b jedes solchen beispielsweise durch einen Motorola-Chip MC 10 102 gegebenen Chip-Bausteins Ch ein beispielsweise durch einen Transistor BC 257 gegebener, nur bei Ansteuerung wenigstens eines Verknüpfungsgliedes Gn des betreffenden Chip-Bausteins Ch leitender Schalttransistor Tb eingefügt. Zu dem Steuereingang des Schalttransistors Tb führt über einen zur Invertierung von Ansteuersignalen eingefügten Transistor Ta ein ODER-Glied D, dessen Eingänge an den Ansteuerleitungen s1 ... s4 der Koppelanordnung liegen. Diese Ansteuerleitungen können übrigens, ohne daß dies in der Zeichnung im einzelnen noch dargestellt wäre, mit den einzelnen Ausgängen eines der Koppelanordnung zugeordneten Ansteuerdecoders verbunden sein.

Wird keiner der auf einem Chip-Baustein Ch zusammengefaßten Koppelpunktschalter Gn von seiner Ansteuerleitung s her angesteuert, so ist zugleich die Zuführung der Betriebsspannung U von beispielsweise −5 V zu dem betreffenden Chip-Baustein Ch hin durch den dann im Sperrzustand befindlichen Schalttransistor Tb unterbrochen; alle Koppelpunktschalter sind dann stromlos und damit verlustleistungsfrei.

Ist einer der Koppelpunktschalter Gn1 ... Gn4 zur Verbindung der zugehörigen Eingangsleitung e1 ... e4 mit der Ausgangsleitung a in den Durchschaltezustand zu steuern und tritt daher auf der zugehörigen Ansteuerleitung s1 ... s4 ein entsprechendes Ansteuersignal auf, so bewirkt dieses Ansteuersignal zunächst einmal über das ODER-Glied D und den Transistor Ta ein Umschalten des Schalters Tb in den leitenden Zustand, so daß dem Chip-Baustein Ch nunmehr die Betriebsspannung U zugeführt wird; damit gelangt auf dem Chip-Baustein der betreffende Koppelpunktschalter Gn1 ... Gn4 in den Durchschaltezustand, während die nichtangesteuerten Koppelpunktschalter des Chip-Bausteins den Sperrzustand einnehmen.

Wir die Verbindung durch Wegnahme des Ansteuersignals von dem betreffenden Ansteuereingang s wieder ausgelöst und befindet sich dann auch kein anderer Koppelpunktschalter des Chip-Bausteins Ch im Durchschaltezustand, so gelangt der Schalttransistor Tb wieder in den Sperrzustand, so daß die Betriebsspannungszuführung zum Chip-Baustein Ch wieder unterbrochen wird und dieser wieder verlustleistungsfrei ist.

Entsprechendes gilt auch für weitere, in der Zeichnung nicht näher dargestellte Chip-Bausteine der Koppelanordnung, in der damit jeweils nur diejenigen Chip-Bausteine verlustleistungsbehaftet sind, die einen gerade im Durchschaltezustand befindlichen Koppelpunktschalter enthalten.

## Patentansprüche

1. Breitbandkoppelanordnung mit Koppelpunktschaltern in ECL-Technik, bei der jeweils eine Mehrzahl von Koppelpunktschaltern durch eine entsprechende Mehrzahl von auf einen Chip-Baustein (Ch) zusammengefaßten Verknüpfungsgliedern (Gn1 ... Gn4) realisiert ist, dadurch gekennzeichnet, daß in eine allen diesen Verknüpfungsgliedern (Gn1 ... Gn4) eines solchen Chip-Bausteins (Ch) gemeinsame Betriebsspannungszuführung (U−b) jedes solchen Chip-Bausteins (Ch) ein nur in Abhängigkeit von einer verknüpfungsgliedindividuellen Ansteuerung wenigstens eines Verknüpfungsgliedes (Gn) des betreffenden Chip-Bausteins (Ch) leitend gesteuerter Schalttransistor (Tb) eingefügt ist.

2. Breitbandkoppelanordnung nach Anspruch 1, dadurch gekennzeichnet, daß die Ansteuereingänge (s1 ... s4) der einzelnen Verknüpfungsglieder (Gn1 ... Gn4) des Chip-Bausteins (Ch) über ein ODER-Glied (D) mit dem Steuereingang des Schalttransistors (Tb) verbunden sind.

3. Breitbandkoppelanordnung nach Anspruch 1 oder 2, dadurch gekennzeichnet, daß die Ansteuereingänge (s1 ... s4) mit den einzelnen Ausgängen eines der Koppelanordnung zugeordneten Ansteuerdecoders verbunden sind.

## Claims

1. A wide-band coupling arrangement having ECL coupling point switches, wherein a plurality of coupling point switches is respectively constructed by a corresponding plurality of logic gate elements (Gn1 ... Gn4) combined on a chip module (Ch), characetrised in that a switching transistor (Tb) only conductively controlled in dependence upon a logic gate element individual drive of at least one switching element (Gn) of the respective chip module (Ch) is inserted into an operating voltage supply line (U−b) of the chip module (Ch) common to all the logic gate elements (Gn1 ... Gn4) of the chip module (Ch).

2. A wide-band coupling arrangement as claimed in Claim 1, characterised in that the drive inputs (s1 ... s4) of the individual logic gate elements (Gn1 ... Gn4) of the chip module (Ch) are connected to the control input of the switching transistor (Tb) by means of an OR-element (D).

3. A wide-band coupling arrangement as claimed in Claim 1 or 2, characterised in that the drive inputs (s1 ... s4) are connected to the individual outputs of a drive decoder which is assigned to the coupling arrangement.

**Revendications**

1. Dispositif de couplage à large bande ccmportant des commutateurs de points de couplage selon la technique ECL, dans lequel respectivement une multiplicité de commutateurs de points de couplage est réalisée au moyen d'une multiplicité correspondante de circuits logiques (Gn1 ... Gn4) réunis sur un module en forme de mocroplaquette (Ch), caractérisé par le fait qu'un transistor de commutation (Tb), qui est placé à l'état conducteur uniquement en fonction d'une sélection, individuelle pour chaque circuit logique, d'au moins un circuit logique (Gn) du module en forme de microplaquette considéré (Ch), est inséré dans une arrivée (U−b) de la tension de service, de chaque module en forme de microplaquette (Ch) commune à tous les circuits logiques (Gn1 ... Gn4) d'un tel module en forme de microplaquette (Ch).

2. Dispositif de couplage à large bande suivant la revendication 1, caractérisé par le fait que les entrées de sélection (s1 ... s4) des différents circuits logiques (Gn1 ... Gn4) du module en forme de microplaquette (Ch) sont reliés par l'intermédiaire d'un circuit OU (D) à l'entrée de commande du transistor de commutation (Tb).

3. Dispositif de couplage à large bande suivant la revendication 1 ou 2, caractérisé par le fait que les entrées de sélection (s1 ... s4) sont reliées aux différentes sorties d'un décodeur de sélection associé au dispositif de couplage.